# EUROPÄISCHE PATENTSCHRIFT

(11) **EP 2 005 561 B1**
(45) Veröffentlichungstag und Bekanntmachung des Hinweises auf die Patenterteilung: **02.09.2009**
(21) Anmeldenummer: 07727093.2
(22) Anmeldetag: 20.03.2007
(51) Int. Cl.: H02K 23/30, G01P 3/48, H02P 7/28, H02P 23/04, H02K 23/66

(54) **ANTRIEBS- UND AUSWERTEEINRICHTUNG**
DRIVE AND EVALUATION UNIT
DISPOSITIF D'ENTRAINEMENT ET D'EVALUATION

(30) Priorität: 03.04.2006 DE 102006015392
(43) Veröffentlichungstag der Anmeldung: 24.12.2008
(73) Patentinhaber: Robert Bosch GmbH, 70442 Stuttgart (DE)
(72) Erfinder: HAUSSECKER, Walter, 77830 Buehlertal (DE); BUEHLER, Dirk, 77815 Buehl (DE); FROEHLICH, Peter, Changsha Hunan 410100 (CN); SCHRAMM, Francois, F-67100 Strasbourg (FR); HERTWECK, Volker, 76532 Baden-Baden (DE)
(86) Internationale Anmeldenummer: PCT/EP2007/052616
(87) Internationale Veröffentlichungsnummer: WO 2007/115907

(56) Entgegenhaltungen:
- EP-A- 1 744 164
- DE-A1-102004 012 431
- US-B1- 6 346 756

## Beschreibung

### Stand der Technik

Die Erfindung betrifft eine Antriebs- und Auswerteeinrichtung, insbesondere zum Anheben und Absenken eines Seitenfensters in einem Kraftfahrzeug, gemäß dem Oberbegriff des Anspruchs 1.

Zur Positionsbestimmung von mit Kommutatormotoren angetriebenen Verstellystemen ist es bekannt, die Welligkeit des Ankerstroms auszuwerten. Dieses Verfahren wird als Ripple Count Verfahren bezeichnet. Dabei wird eine zur Motordrehzahl proportionale, dem Ankerstrom aufmodulierte Frequenz mittels einer Auswerteeinrichtung analysiert. Die mögliche, zu diesem Zweck heranziehbare systemcharakteristische Frequenz wird durch die Kommutierung zwischen den einzelnen Ankerwicklungen verursacht und ermöglicht damit eine Unterteilung einer Umdrehung des Ankers des Elektromotors in eine der Anzahl der Kommutierungen entsprechende Anzahl Teilumdrehungen, so dass beispielsweise bei sechs Segmenten des Kommutators sechs Strom-Welligkeitsmaxima pro Ankerumdrehung auftreten. Diese werden von der Auswerteeinrichtung gezählt. Da eine feste Relation zwischen der Umdrehung des Ankers des Kommutatormotors und der Position des Verstellobjekts besteht, kann über die Auswertung der Position des Kommutatormotors die Position des Verstellobjekts bestimmt werden. Problematisch bei bekannten Antriebs- und Auswerteeinrichtungen ist, dass die Amplituden der dem Ankerstrom aufmodulierten Schwingung meist eine so geringe Intensität haben, dass es zu Fehlzählungen und damit zu Fehlpositionsbestimmungen kommt.

### Offenbarung der Erfindung

Technische Aufgabe

Der Erfindung liegt die Aufgabe zugrunde, eine verbesserte Antriebs- und Auswerteeinrichtung anzugeben, mit der die Wahrscheinlichkeit von Fehlzählungen der Amplituden einer dem Ankerstrom aufmodulierten, systemcharakteristischen Schwingung reduziert wird.

### Technische Lösung

Diese Aufgabe wird mit den Merkmalen des Anspruches 1 gelöst.

Vorteilhafte Weiterbildungen der Erfindung sind in den Unteransprüchen angegeben.

Der Erfindung liegt der Gedanke zugrunde, einen speziell ausgebildeten Kommutatormotor mit einer an sich bekannten Auswerteeinrichtung zum Zählen von Amplituden einer systemcharakteristischen Schwingung des Kommutatormotors zu kombinieren. Der Kommutatormotor weist zehn in Umfangsrichtung beabstandete Nuten zur Aufnahme der Anker- bzw. Spulenwicklungen auf. Erfindungsgemäß ist vorgesehen, dass die Ankerwicklung nicht als Durchmesserwicklung, sondern als Sehnenwicklung mit einer Spulenweite von y1=3 ausgeführt ist. Dies bedeutet, dass der Leiter einer Spulenwicklung der Nut n auch durch die Nut n+3 geführt ist. Hierdurch ist zwar eine Verschlechterung des Wirkungsgrades und des Geräuschverhaltens möglich, jedoch wird in Kombination mit der speziellen, erfindungsgemäßen Permanentmagnetgeometrie eine Erhöhung der Amplituden einer dem Ankerstrom aufmodulierten Schwingung erreicht, die ihre Ursache in dem Verlauf der induzierten Spannung und der durch die Kommutierung hervorgerufenen periodischen Kurzschlussströme in den Ankerwicklungen hat. Durch größere Amplituden wird die Wahrscheinlichkeit von Fehlzählungen durch die an sich bekannte Auswerteeinrichtung reduziert. Erfindungsgemäß ist vorgesehen, dass der dem Anker zugewandte, radial innere Umfangskonturabschnitt einer Querschnittsfläche des Permanentmageneten den Anker über einen inneren Umfangswinkel α₄ aus einem Bereich zwischen 101° und 111° umgreift. Bevorzugt beträgt der innere Umfangswinkel α₁ etwa 106°. Der innere Umfangskonturabschnitt endet dort, wo der Luftspalt zwischen Permanentmagnet und Anker sprunghaft ansteigt.

In Weiterbildung der Erfindung ist vorgesehen, dass der gesamte radial innere Umfangskonturabschnitt einen teilkreisförmigen Verlauf um einen Mittelpunkt M_{Ui} aufweist.

Die Amplituden der dem Ankerstrom aufmodulierten, systemcharaktieristischen Schwingung können weiter dadurch erhöht werden, dass die Querschnittsfläche des Permanentmagneten einen radial äußeren Umfangskonturabschnitt aufweist, der ebenfalls teilkreisförmig ausgeformt ist. Alle weiteren Umfangskonturabschnitte der Querschnittsfläche, also die den inneren und den äußeren, jeweils teilkreisförmigen Umfangskonturabschnitt verbindenden Umfangskonturabschnitte stellen so genannte seitliche Umfangskonturabschnitte dar.

Erfindungsgemäß ist vorgesehen, dass die seitlichen Umfangskonturabschnitte den inneren und den äußeren Umfangskonturabschnitt zumindest bereichsweise in Umfangsrichtung überragen. Die beiden in Umfangsrichtung am weitesten voneinander entfernten Punkte der Querschnittsfläche des Permanentmagneten umgreifen den Anker über einen maximalen Umfangswinkel αₘₐₓ aus einem Winkelbereich zwischen 106° und 117°. Vorzugsweise beträgt der maximale Umfangswinkel der zwei in Umfangsrichtung voneinander am weitesten entfernten Punkte des Permanentmagneten etwa 111°.

Bevorzugt lassen sich die seitlichen Umfangskonturabschnitte in drei Teilabschnitte unterteilen. Der erste Teilabschnitt verläuft von den in Umfangsrichtung beabstandeten Enden des inneren Umfangskonturabschnitts nach schräg außen, also teilweise auch in Umfangsrichtung. Es hat sich als vorteilhaft erwiesen, dass der erste Teilabschnitt unter einem Winkel aus einem Bereich zwischen 20° und 30°, vorzugsweise von 25° zu einer Achse verläuft, die senkrecht zu einer Symmetrieachse der Querschnittsfläche des Permanentmagneten ausgerichtet ist. In Weiterbildung der Erfindung schließt an den ersten Teilabschnitt der zweite Teilabschnitt des seitlichen Umfangskonturabschnittes an. Dieser verläuft bevorzugt parallel zur Symmetrieachse der Querschnittsfläche und in Richtung des äußeren Umfangskonturabschnitts. Die Enden der zweiten Teilabschnitte wiederum sind mit den in Umfangsrichtung beabstandeten Enden der äußeren Umfangskonturabschnitte über jeweils einen dritten, um den Schnittpunkt der Symmetrieachse mit der Drehachse des Ankers teilkreisförmig gekrümmten Teilabschnitt verbunden. Die Verbindungspunkte zwischen den dritten Teilabschnitten und dem äußeren Umfangskonturabschnitt bilden Auflagepunkte zur Abstützüng des Permanentmagneten in einem Motorgehäuse.

Bevorzugt sind die beiden gegenüberliegenden Permanentmagnete mit entgegengesetzter Polung identisch ausgeformt. Die Permanentmagnete stützen sich gegeneinander über mindestens eine Feder.ab und werden durch die Federkraft in Richtung Motorgehäuse gedrückt. Ebenso ist ein Ankleben der Magnete an dem Motorgehäuse möglich.

### Kurze Beschreibung der Zeichnungen

Weitere Vorteile und zweckmäßige Ausführungen sind den weiteren Ansprüchen, der Figurenbeschreibung und den Zeichnungen zu entnehmen. Es zeigen:
- Fig. 1: eine schematische Schnittdarstellung des Kommutatormotors, und
- Fig. 2: eine Schnittdarstellung eines Permanentmagneten des Kommutatormotors gemäß Fig. 1.

In den Figuren sind gleiche Bauteile und Bauteile mit gleicher Funktion mit den gleichen Bezugszeichen gekennzeichnet.

### Ausführungsformen der Erfindung

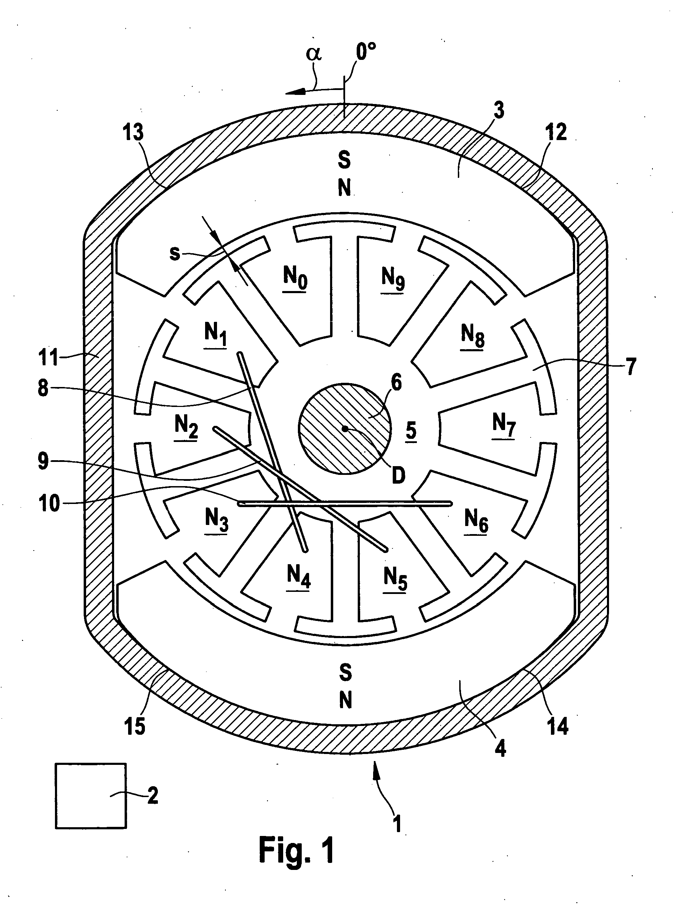

In Fig. 1 ist ein Kommutatormotor 1 und eine Auswerteeinrichtung 2 gezeigt. Die Auswerteeinrichtung 2 ist über nicht dargestellte elektrische Verbindungsleitungen mit dem nicht dargestellten Stromversorgungskreis der nicht dargestellten, zwei Kommutatorbürsten verbunden. Die Auswerteeinrichtung 2 zählt die Amplituden einer zu der Drehzahl des Kommutatormotors 1 proportionalen Schwingung, die dem Ankerstrom aufmoduliert wird. Diese Schwingung hat ihre Ursache in der wechselnden Kommutierung der Ankerwicklungen und dem Verlauf der induzierten Spannung innerhalb einer Teilspule.

Der Kommutatormotor 1 weist zwei diametral gegenüberliegende Permanentmagnete 3, 4 mit gegensätzlicher Polung auf. Radial innerhalb der Permanentmagnete 3, 4 ist drehbar ein im Wesentlichen zylinderförmiger Anker 5 mit einer Ankerwelle 6 angeordnet. Die Drehachse der Ankerwelle 6 ist mit D bezeichnet. Der Anker 5 weist zehn in Umfangsrichtung beabstandete, V-förmige Nuten N₀ bis N₉ auf. Jeweils zwei benachbarte Nuten sind durch einen von insgesamt zehn Polzähnen 7 voneinander abgegrenzt. Die Nuten N₀ bis N₉ dienen zur Aufnahme der Ankerwicklungen, von denen beispielhaft nur drei Ankerwicklungen 8, 9, 10 dargestellt sind. Die Ankerwicklungen sind als Sehnenwicklungen mit einer Spulenweite von y1=3 ausgebildet. Die Ankerwicklung durch die Nut n verläuft also auch durch die Nut n+3. Beispielsweise verläuft die Ankerwicklung 8 durch die Nuten N₁ und N₄, die Ankerwicklung durch die Nut N₂ verläuft auch durch die Nut N₅ und die Ankerwicklung 10 durch die Nut N₃ verläuft auch durch die Nut N₆. Durch die Nut N₁ verläuft weiterhin eine nicht dargestellte Ankerwicklung, die zusätzlich durch die Nut N₈ verläuft, so dass insgesamt zehn Anker- bzw. Spulenwicklungen vorgesehen sind. Jeder Spulenwicklung ist ein nicht dargestelltes Kommutatorsegment zugeordnet, so dass durch die induzierte Spannung und durch die Kommutierungsvorgänge während einer Umdrehung eine Schwingung mit zehn oder einem Vielfachen von zehn Amplituden erzeugt wird, die dem der Auswerteeinheit 2 zugeführten Ankerstrom aufmoduliert werden. Die Anzahl der Amplituden ist proportional zur Drehzahl bzw. Umdrehung des Ankers 5, so dass durch Zählen der Amplituden (Ripple Count) auf die Ankerposition und damit auf die Position eines Verstellobjekts, insbesondere einer Seitenscheibe in einem KFZ, geschlossen werden kann. Die als SchleifenWicklungen ausgeführten Ankerwicklungen können entweder über Kreuz oder nicht gekreuzt an die Kommutatorsegmente angeschlossen werden.

Der Kommutatormotor 1 ist in einem Polgehäuse 11 angeordnet. Die Permanentmagnete 3, 4 liegen an jeweils zwei senkrecht zur Zeichnungsebene verlaufenden Auflagelinien 12, 13, 14, 15 an der Innenwand des Gehäuses 11 an, wodurch eine exakte Positionierung in dem Gehäuse 11 möglich ist. Die beiden Permanentmagnete 3, 4 stützen sich über nicht dargestellte Federn gegeneinander ab und werden so mit den Anlagelinien 12 bis 15 an die Innenwand des Gehäuses 11 gedrückt. Der Luftspalt s zwischen dem Anker 5 und den Permanentmagneten 3, 4 verändert sich in Umfangsrichtung. Der Luftspalt s verbreitert sich ausgehend von der Mitte zu den in Umfangsrichtung beabstandeten Enden der Permanentmagnete 3, 4 hin.

Der Umfangswinkel in Bezug auf die Drehachse D ist mit α bezeichnet.

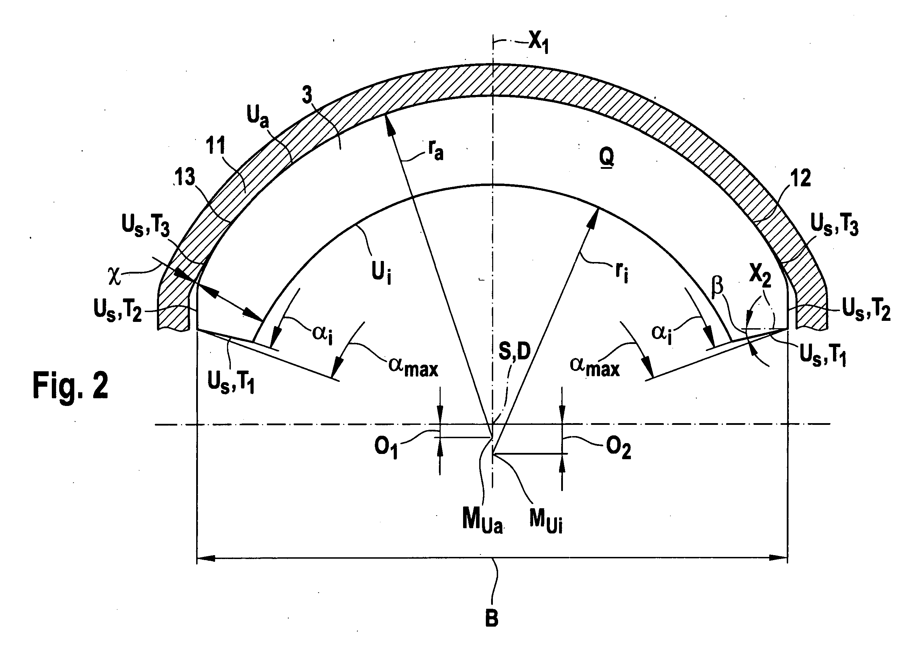

Durch die Kombination der Ankerwicklungen mit einer Spulenweite von y1=3, den insgesamt zehn Nuten und der speziellen Geometrie der Permanentmagnete werden die Amplituden der drehzahlproportionalen Schwingung vergrößert. Die erfindungsgemäße Geometrie zumindest eines der Permanentmagnete 3, 4, vorzugsweise beider Permanentmagnete 3, 4, ist im Folgenden anhand von Fig. 2 näher erläutert.

Wesentliches Merkmal ist die Umfangserstreckung des radial inneren Umfangskonturabschnitts Uᵢ der Querschnittsfläche Q der Permanentmagnete 3, 4.

Der radial innere Umfangskonturabschnitt Uᵢ erstreckt sich über einen Umfangswinkel αᵢ in Bezug auf die Drehachse D des Ankers von 106°. Der radial innere Umfangskonturabschnitt Uᵢ ist teilkreisförmig mit einem Radius rᵢ=15,8±0,5mm um einen Mittelpunkt M_{Ui} ausgebildet. Mit radialem Abstand zu dem inneren Umfangskonturabschnitt Uᵢ ist ein ebenfalls teilkreisförmiger äußerer Umfangskonturabschnitt Uₐ vorgesehen. Der Radius des radial äußeren Umfangskonturabschnitts Uₐ um einen Mittelpunkt M_{Ua} beträgt 20, 2±0, 5mm. Beide Mittelpunkte M_{Ui} und M_{Ua} liegen auf einer Symmetrieachse X₁ der Querschnittsfläche Q des Permanentmagenten 3. Diese Symmetrieachse X₁ schneidet die Drehachse D des Ankers im Punkt S. Der Mittelpunkt des radial äußeren Umfangskonturabschnitts Uₐ befindet sich in der Zeichnungsebene um einen Offsetwert O₁ von 0,33±0,5mm in Bezug auf den Schnittpunkt S nach unten versetzt. Der Mittelpunkt M_{Ui} des radial inneren Umfangskonturabschnitts Uᵢ ist um einen Offsetwert O₂ von 1,28±0,5mm in Bezug auf den Schnittpunkt S in der Zeichnungsebene nach unten versetzt.

Der äußere Umfangskonturabschnitt Uₐ und der innere Umfangskonturabschnitt Uᵢ sind über zwei seitliche Umfangskonturabschnitte Uₛ miteinander verbunden. Die seitlichen Umfangskonturabschnitte Uₛ sind jeweils unterteilt in drei Teilabschnitte, nämlich einen ersten Teilabschnitt T₁, einen zweiten Teilabschnitt T₂ und einen dritten Teilabschnitt T₃. Die ersten Teilabschnitte T₁ verlaufen unter einem Winkel β=25° zu einer Achse X₂ von den in Umfangsrichtung beabstandeten Enden des inneren Umfangskonturabschnitts nach außen. Die Achse X₂ verläuft senkrecht zur Symmetrieachse X₁. An die ersten Teilabschnitte T₁ schließen die zweiten Teilabschnitte T₂ an. Diese verlaufen parallel zur Symmetrieachse X₁ und bilden zusammen mit den Teilabschnitten T₁ eine Art in etwa in Umfangsrichtung weisende Pfeilspitzen. Der Abstand B der beiden Teilabschnitte T₂ bzw. der Pfeilspitzen zueinander beträgt 30,5 mm und stellt die maximale Breite des Permanentmagneten dar.

An die zweiten Teilabschnitte T₂ schließen die in Richtung radial äußerem Umfangskonturabschnitt Uₐ verlaufenden dritten Teilabschnitte T₃ an. Diese verlaufen teilkreisförmig um den Schnittpunkt S der Symmetrieachse X₁ mit der Drehachse D des Ankers 5. Dort, wo die dritten Teilabschnitte T₃ auf den äußeren Umfangskonturabschnitt Uₐ treffen, sind zwei in Umfangsrichtung beabstandete Anlagepunkte bzw. senkrecht zur Zeichnungsebene verlaufenden Anlagelinien 12, 13, 14, 15 gebildet, mit denen die Permanentmagnete 3, 4 an dem Gehäuse 11 anliegen. Die dritten Teilabschnitte T₃ schließen mit der Innenseite des Gehäuses 11 in Umfangsrichtung sich vergrößernde Winkel χ ein.

## Patentansprüche

1. Antriebs- und Auswerteeinrichtung zur Verstellung eines Verstellobjekts, insbesondere zum Anheben und Absenken eines Seitenfensters in einem Kraftfahrzeug, mit einem Kommutatormotor (1) mit einem Stator und mit zwei diametral gegenüberliegenden Permanentmagneten (3, 4), deren Querschnittsflächen (Q) jeweils eine Umfangskonturabschnitt mit einem radial inneren Umfangskonturabschnitt (Uᵢ) aufweisen, mit dem die Permanentmagnete einen Anker (5) mit zehn in Umfangrichtung beabstandeten Nuten (No bis N₉), zur Aufnahme von als Schleifenwicklungen ausgeführten Ankerwicklungen (8, 9, 10), über jeweils einen inneren Umfangswinkel α₁ umgreifen, sowie mit einer Einrichtung zur Drehpositionsbestimmung des Ankers (5) durch Auswertung der Welligkeit des Ankerstroms (Ripple Count),
**dadurch gekennzeichnet,**
**dass** die Ankerwicklungen (8, 9, 10) als Sehnenwicklung mit einer Spulenweite von y1=3 ausgeführt sind, und dass der innere Umfangswinkel α₁ des radial inneren Umfangskonturabschnitts (Uᵢ) mindestens eines der Permanentmagnete (3, 4) mindestens 101° und maximal 111°, vorzugsweise 106°, beträgt.

2. Einrichtung nach Anspruch 1,
**dadurch gekennzeichnet,**
**dass** der radial innere Umfangskonturabschnitt (Uᵢ) einen teilkreisförmigen Verlauf aufweist.

3. Einrichtung nach Anspruch 1 oder 2,
**dadurch gekennzeichnet,**
**dass** ein radial äußerer Umfangskonturabschnitt (Uₐ) der Querschnittsfläche (Q) des Permanentmagneten (3, 4) einen teilkreisförmigen Verlauf aufweist.

4. Einrichtung nach Anspruch 3,
**dadurch gekennzeichnet,**
**dass** eine erste Achse (X₁), auf der die Mittelpunkte (M_{Ui}, M_{Ua}) des radial inneren Umfangskonturabschnitts (Uᵢ) und des radial äußeren Umfangskonturabschnitts (Uₐ) liegen, die Drehachse (D) des Ankers (5) schneidet, und dass die Mittelpunkte (M_{Ui}, M_{Ua}) und der Schnittpunkt (S) jeweils mit Abstand zueinander angeordnet sind.

5. Einrichtung nach Anspruch 4,
**dadurch gekennzeichnet,**
**dass** die erste Achse (X₁) die Symmetrieachse der Querschnittsfläche (Q) des Permanentmagneten (3, 4) ist.

6. Einrichtung nach einem der vorhergehenden Ansprüche,
**dadurch gekennzeichnet,**
**dass** auf zwei in Umfangsrichtung beabstandeten Seiten des Permanentmagneten (3, 4) jeweils ein, den radial inneren und den radial äußeren Umfangskonturabschnitt (U₁, Uₐ) miteinander verbindender, seitlicher Umfangskonturabschnitt (Uₛ) vorgesehen ist, wobei die beiden seitlichen Umfangskonturabschnitte (Uₛ) den radial inneren Umfangskonturabschnitt (Uᵢ) in Umfangsrichtung überragen, derart, dass der Permanentmagnet (3, 4) den Anker (5) über einen maximalen Umfangswinkel αₘₐₓ von minimal 106° und maximal 117°, vorzugsweise von 111°, umgreift.

7. Einrichtung nach einem der Ansprüche 4 bis 6,
**dadurch gekennzeichnet,**
**dass** die seitlichen Umfangskonturabschnitte (Uₛ) einen ersten Teilabschnitt (T₁) aufweisen, der sich von dem radial inneren Umfangskonturabschnitt (Uᵢ) unter einem Winkel β von mindestens 20° und maximal 30°, vorzugsweise von 25°, zu einer senkrecht zur ersten Achse (X₁) verlaufenden zweiten Achse (X₂) nach schräg außen sowie in Umfangsrichtung erstreckt.

8. Einrichtung nach einem der vorhergehenden Ansprüche,
**dadurch gekennzeichnet,**
**dass** an jedem ersten Teilabschnitt (T₁) der seitlichen Umfangskonturabschnitte (Uₛ) ein zweiter Teilabschnitt (T₂) anschließt, der parallel zu der ersten Achse (X₁) verläuft.

9. Einrichtung nach Anspruch 8,
**dadurch gekennzeichnet,**
**dass** das radial äußere Ende jedes zweiten Teilabschnitts (T₂) der seitlichen Umfangskonturabschnitte (Uₛ) über einen dritten, teilkreisförmigen Teilabschnitt (T₃) mit dem radial äußeren Umfangskonturabschnitt (Uₐ) verbunden ist.

10. Einrichtung nach Anspruch 9,
**dadurch gekennzeichnet,**
**dass** die dritten Teilabschnitte (T₃) der seitlichen Umfangskonturabschnitte (Uₛ) um den Schnittpunkt der ersten Achse (X₁) mit der Drehachse (D) des Ankers (5) teilkreisförmig gekrümmt sind.

## Claims

1. Drive and evaluation device for adjusting an adjustable object, in particular for raising and lowering a side window in a motor vehicle, having a commutator motor (1) with a stator and with two diametrically opposite permanent magnets (3, 4), of which the cross-sectional areas (Q) each have a circumferential contour section with a radially inner circumferential contour section (Uᵢ) with which the permanent magnets surround an armature (5) having ten slots (No to N₉), which are spaced apart in the circumferential direction, for accommodating armature windings (8, 9, 10), which are designed as lap windings, over an inner circumferential angle α₁ in each case, and also having a device for determining the rotation position of the armature (5) by evaluating the ripple of the armature current (ripple count),
**characterized**
**in that** the armature windings (8, 9, 10) are designed as fractional pitch windings with a coil width of y1=3, and in that the inner circumferential angle α₁ of the radially inner circumferential contour section (Uᵢ) of at least one of the permanent magnets (3, 4) is at least 101° and at most 111°, preferably 106°.

2. Device according to Claim 1,
**characterized**
**in that** the radially inner circumferential contour section (Uᵢ) has a profile which is in the form of part of a circle.

3. Device according to Claim 1 or 2,
**characterized**
**in that** a radially outer circumferential contour section (Uₐ) of the cross-sectional area (Q) of the permanent magnet (3, 4) has a profile which is in the form of part of a circle.

4. Device according to Claim 3,
**characterized**
**in that** a first axis (X₁), on which the centre points (M_{Ui}, M_{Ua} of the radially inner circumferential contour section (Uᵢ) and of the radially outer circumferential contour section (Uₐ) lie, intersects the rotation axis (D) of the armature (5), and in that the centre points (M_{Ui}, M_{Ua} and the point (S) of intersection are in each case arranged at a distance from one another.

5. Device according to Claim 4,
**characterized**
**in that** the first axis (X₁) is the axis of symmetry of the cross-sectional area (Q) of the permanent magnet (3, 4).

6. Device according to one of the preceding claims,
**characterized**
**in that** a lateral circumferential contour section (Uₛ) which connects the radially inner and the radially outer circumferential contour sections (Uᵢ, Uₐ) to one another is provided in each case on two sides of the permanent magnet (3, 4) which are spaced apart in the circumferential direction, with the two lateral circumferential contour sections (Uₛ) projecting beyond the radially inner circumferential contour section (Uᵢ) in the circumferential direction in such a way that the permanent magnet (3, 4) surrounds the armature (5) over a maximum circumferential angle αₘₐₓ of at least 106° and at most 117°, preferably 111°.

7. Device according to one of Claims 4 to 6,
**characterized**
**in that** the lateral circumferential contour sections (Uₛ) have a first subsection (T₁) which extends obliquely outward and in the circumferential direction from the radially inner circumferential contour section (Uᵢ) at an angle β of at least 20° and at most 30°, preferably of 25°, to a second axis (X₂) which runs perpendicular to the first axis (X₁).

8. Device according to one of the preceding claims,
**characterized**
**in that** a second subsection (T₂), which runs parallel to the first axis (X₁), adjoins each first subsection (T₁) of the lateral circumferential contour sections (Uₛ).

9. Device according to Claim 8,
**characterized**
**in that** the radially outer end of each second subsection (T₂) of the lateral circumferential contour sections (Uₛ) is connected to the radially outer circumferential contour section (Uₐ) by means of a third subsection (T₃) which is in the form of part of a circle.

10. Device according to Claim 9,
**characterized**
**in that** the third subsections (T₃) of the lateral circumferential contour sections (Uₛ) are bent in the form of part of a circle around the point of intersection of the first axis (X₁) with the rotation axis (D) of the armature (5).

## Revendications

1. Dispositif d'entraînement et d'évaluation pour déplacer un objet mobile, en particulier pour lever et abaisser une fenêtre latérale dans un véhicule automobile, comprenant un moteur à commutateur (1) avec un stator et avec deux aimants permanents (3, 4) diamétralement opposés, dont les surfaces en section transversale (Q) présentent chacune une portion de contour périphérique avec une portion de contour périphérique radialement interne (Uᵢ), avec laquelle les aimants permanents viennent en prise, sur un angle périphérique interne α₁, avec un induit (5) ayant dix rainures espacées dans la direction périphérique (N₀ à N₉), pour recevoir des enroulements d'induit (8, 9, 10) réalisés sous forme d'enroulements imbriqués, et comprenant également un dispositif pour déterminer la position de rotation de l'induit (5) par évaluation de l'ondulation du courant d'induit (Ripple Count),
**caractérisé en ce que**
les enroulements d'induit (8, 9, 10) sont réalisés sous forme d'enroulement de corde avec une largeur de bobine de y1=3, et **en ce que** l'angle périphérique interne α₁ de la portion de contour périphérique radialement interne (Uᵢ) d'au moins l'un des aimants permanents (3, 4) vaut au moins 101° et au plus 111°, de préférence 106°.

2. Dispositif selon la revendication 1,
**caractérisé en ce que**
la portion de contour périphérique radialement interne (Uᵢ) présente une allure en forme de cercle partiel.

3. Dispositif selon la revendication 1 ou 2,
**caractérisé en ce**
**qu'**une portion de contour périphérique radialement externe (Uₐ) de la surface en section transversale (Q) de l'aimant permanent (3, 4) présente une allure en forme de cercle partiel.

4. Dispositif selon la revendication 3,
**caractérisé en ce**
**qu'**un premier axe (X₁), sur lequel se trouvent les centres (M_{Ui}, M_{Ua}) de la portion de contour périphérique radialement interne (Uᵢ) et de la portion de contour périphérique radialement externe (Uₐ), coupe l'axe de rotation (D) de l'induit (5), et en ce que les centres (M_{Ui}, M_{Ua}) et le point d'intersection (S) sont à chaque fois disposés à distance les uns des autres.

5. Dispositif selon la revendication 4,
**caractérisé en ce que**
le premier axe (X₁) est l'axe de symétrie de la surface en section transversale (Q) de l'aimant permanent (3, 4).

6. Dispositif selon l'une quelconque des revendications précédentes, **caractérisé en ce que** sur deux côtés de l'aimant permanent (3, 4) espacés dans la direction périphérique, est prévue à chaque fois une portion de contour périphérique (Uₛ) latérale, reliant ensemble la portion de contour périphérique radialement interne et la portion de contour périphérique radialement externe (Uᵢ, Uₐ), les deux portions de contour périphérique latérales (Uₛ) faisant saillie dans la direction périphérique au-delà de la portion de contour périphérique radialement interne (Uᵢ), de telle sorte que l'aimant permanent (3, 4) vienne en prise autour de l'induit (5) sur un angle périphérique maximal αₘₐₓ d'au moins 106° et d'au plus 117°, de préférence de 111°.

7. Dispositif selon l'une quelconque des revendications 4 à 6,
**caractérisé en ce que**
les portions de contour périphérique latérales (Uₛ) présentent une première portion partielle (T₁) qui s'étend obliquement vers l'extérieur et dans la direction périphérique depuis la portion de contour périphérique radialement intérieure (Uᵢ) suivant un angle β d'au moins 20° et d'au plus 30°, de préférence de 25°, par rapport à un deuxième axe (X₂) s'étendant perpendiculairement au premier axe (X₁).

8. Dispositif selon l'une quelconque des revendications précédentes,
**caractérisé en ce**
**qu'**une deuxième portion partielle (T₂), qui s'étend parallèlement au premier axe (X₁), se raccorde à chaque première portion partielle (T₁) des portions de contour périphérique latérales (Uₛ).

9. Dispositif selon la revendication 8,
**caractérisé en ce que**
l'extrémité radialement extérieure de chaque deuxième portion partielle (T₂) des portions de contour périphérique latérales (Uₛ) est connectée par le biais d'une troisième portion partielle en forme de cercle partiel (T₃) à la portion de contour périphérique radialement externe (Uₐ).

10. Dispositif selon la revendication 9,
**caractérisé en ce que**
les troisièmes portions partielles (T₃) des portions de contour périphérique latérales (Uₛ) sont courbées en forme de cercle partiel autour du point d'intersection du premier axe (X₁) avec l'axe de rotation (D) de l'induit (5).
